Europäisches Patentamt

**European Patent Office**

Office européen des brevets

(19)

(11) Veröffentlichungsnummer: **0 021 147**
**B1**

(12) **EUROPÄISCHE PATENTSCHRIFT**

(45) Veröffentlichungstag der Patentschrift:
29.01.86

(21) Anmeldenummer: 80103086.7

(22) Anmeldetag: 03.06.80

(51) Int. Cl.⁴: **H 01 L 21/76, H 01 L 21/90,**
**H 01 L 21/263, H 01 L 21/316,**
**H 01 L 23/52**

(54) Verfahren zur Herstellung von breiten, tief eingeschnittenen Isolationsgräben in einem Halbleitersubstrat.

(30) Priorität: 28.06.79 SA 52997

(43) Veröffentlichungstag der Anmeldung:
07.01.81 Patentblatt 81/1

(45) Bekanntmachung des Hinweises auf die Patenterteilung:
29.01.86 Patentblatt 86/5

(84) Benannte Vertragsstaaten:
DE FR GB

(56) Entgegenhaltungen:
FR - A - 2 328 288
US - A - 3 938 241
US - A - 3 966 577
US - A - 4 139 442
US - A - 4 140 558

IBM TECHNICAL DISCLOSURE BULLETIN, Band 21, Nr. 8, Januar 1979, Seiten 3246-3247, New York, USA H.B. POGGE et al.: "Fabrication of narrow signal and bus lines on a MOSFET chip"

(73) Patentinhaber: International Business Machines Corporation, Old Orchard Road, Armonk, N.Y. 10504 (US)

(72) Erfinder: Horng, Cheng Tzong, 22 Concord Road, Fishkill New York 12524 (US)
Erfinder: Schwenker, Robert Otto, 6359 Gondola Way, San Jose California 95120 (US)

(74) Vertreter: Gaugel, Heinz, Dipl.-Ing., Schönaicher Strasse 220, D-7030 Böblingen (DE)

**Beschreibung**

Die Erfindung geht aus von einem bekannten Verfahren (US-A-4 139 442) zur Herstellung von Isolationsgräben in einem Halbleitersubstrat, die durch reaktives Ionenätzen gebildet werden. Diese Isolationsgräben haben die Aufgabe es zu ermöglichen, dass die verschiedenen aktiven und passiven Schaltelemente einer Halbleiteranordnung so verbunden werden können, dass sie vom Halbleitersubstrat wirksam isoliert sind, und dass eine unerwünschte kapazitive Kopplung der Leitungsverbindungen zu dem Halbleitersubstrat vermieden wird. Zur Herstellung solcher Isolationsgräben an einer Halbleiteroberfläche ist es bekannt (US-A-4 139 442), durch ein Photolithographieverfahren und reaktives Ionenätzen Kanäle kleinster Abmessungen in die Oberfläche einer Halbleiterstruktur einzufügen. Die Querschnittsprofile der Kanäle haben verschiedene Tiefen, zwischen denen Zwischenwände aus einem Halbleitermaterial angeordnet sind, die einen mesaförmigen Querschnitt in verschiedener Höhe aufweisen. Die Breite einer jeden Zwischenwand wird bestimmt durch die Dicke der Siliciumschicht, aus welcher das Halbleitermaterial besteht. Die resultierende Struktur des Halbleitermaterials wird sodann oxidiert, und die nicht mit Halbleiterstrukturen gefüllten Volumina der Verbindungskanäle werden gefüllt mit einem dielektrischen Material.

Somit ist aus der US-A-4 139 442 ein Verfahren zur Herstellung von breiten, tief eingeschnittenen Isolationsgräben in einem Halbleitersubstrat bekannt, bei dem das Substrat einer reaktiven Ionenätzung unterworfen wird, um eine Folge tiefer Gräben zu erzeugen, die durch schmale mesaförmige Zwischenwände voneinander getrennt sind und bei dem das Material der Zwischenwände vollständig thermisch oxidiert wird.

Bei dem bekannten Verfahren besteht die Schwierigkeit, durch das Photolithographieverfahren die erforderliche Präzision der Abmessungen der verschiedenen Kanäle und Zwischenwände zu erreichen.

Es ist die Aufgabe der vorliegenden Erfindung, so wie sie in den Ansprüchen definiert ist, ein Verfahren anzugeben, bei welchem die Genauigkeit der Abmessungen der zu oxidierenden Zwischenwände erhöht wird.

Das erfindungsgemässe Verfahren weist den Vorteil auf, dass sich die Dicke der Zwischenwände genau einstellen lässt, so dass die Zwischenwände zwischen den Kanälen eine ausreichende Festigkeit aufweisen, durch welche mechanische Beschädigungen ihrer Oberflächenstruktur vermieden werden und so dass andererseits die Abmessungen der Zwischenwände nicht zu gross sind, um übermässige thermische Oxidationszeiten zu verhindern.

Die Erfindung wird anhand von Abbildungen näher erläutert.

Es zeigen:

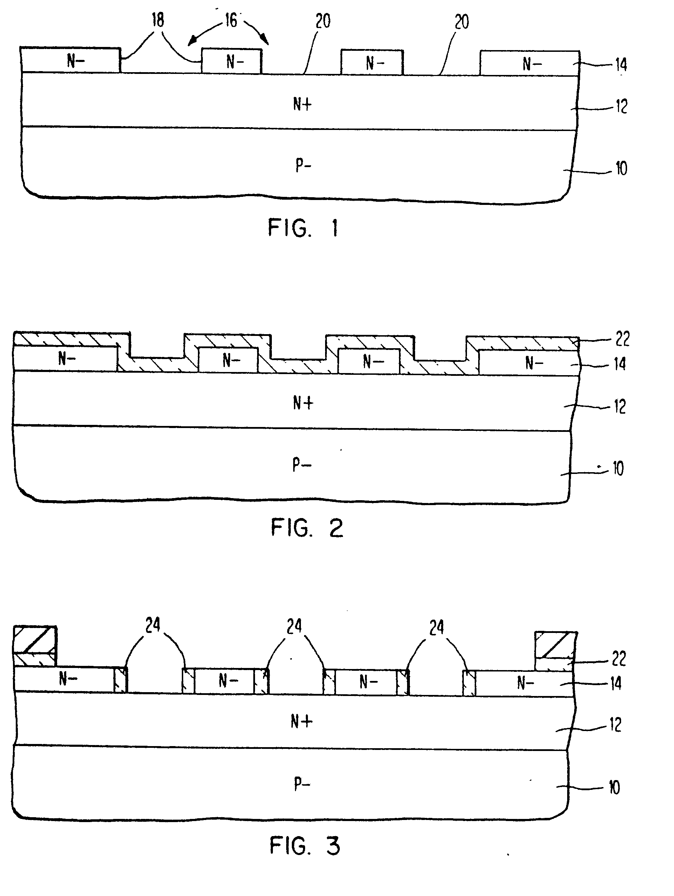

Die Fig. 1 bis 5 verschiedene Verfahrensschritte bei der Erzeugung von breiten, tief eingeschnittenen Isolationsgräben gemäss der vorliegenden Erfindung.

Die in Fig. 1 gezeigte Struktur besteht aus einem monokristallinen Siliciumsubstrat 10, einer $N^+$-Schicht 12, die über dem Halbleitersubstrat 10 angeordnet ist, und der Schicht 14 der negativen Leitfähigkeit $N^-$. Für den Zweck der vorliegenden Erfindung könnten entweder alle oder nur einige der Schichten 10, 12 und 14 auch eine entgegengesetzte Leitfähigkeit aufweisen. Es wird jedoch bevorzugt, dass die Schicht 12 eine hohe Leitfähigkeit aufweist, wo ihr zugeordnete Teile als Subkollektoren von bipolaren Transistoren benützt werden.

Die in Fig. 1 dargestellte Struktur kann auf verschiedene Arten hergestellt werden. Die bevorzugte Technik besteht jedoch darin, ein $P^-$-monokristallines Siliciumsubstrat 10 zu verwenden, in welches zur Erzeugung der Schicht 12 eine $N^+$-Schicht durch eine Diffusion bekannter Art eindiffundiert wird. Ferner kann eine Ionenimplantation einer N-Verunreinigung, wie z. B. Arsen, Antimon oder Phosphor durchgeführt werden, um eine $N^+$-Schicht 12 mit einer Oberflächenkonzentration zwischen ungefähr $1 \times 10^{19}$ bis $1 \times 10^{21}$ Atomen/$cm^3$ zu erzeugen. Die Schicht 14 wird anschliessend durch epitaxiales Aufwachsen über der Schicht 12 angeordnet. Dies kann durch eine bekannte Technik, wie z. B. durch die Anwendung von $SiCl_4/H_2$ oder $SiH_4/H_2$-Mischungen bei Aufwachstemperaturen von ungefähr 1000 bis 1200 °C erfolgen. Die $N^+$-Schicht 12 kann eine Dicke von ungefähr 1 bis 3 $\mu$ aufweisen, wobei die Epitaxialschicht 14 eine Dicke von ungefähr 0,5 bis 10 $\mu$ aufweisen kann.

Wahlweise könnte die beschriebene Struktur durch verschiedene Kombinationen von thermischer Diffusion, Ionenimplantation und/oder epitaxialem Aufwachsen hergestellt werden, in der Weise, dass die Struktur einen vergrabenen Subkollektor-Bereich aufweist, wenn anschliessend die Herstellung eines Bipolar-Transistors gewünscht wird. In bestimmten Halbleiterstrukturen sind hochdotierte vergrabene Regionen oder Schichten nicht notwendig und können daher ausgelassen werden. Dies gilt für FET-Anordnungen. Wahlweise können mehrfach vergrabene hochdotierte Regionen von verschieden dotierten Halbleitertypen durch ein Mehrfach-Epitaxial- und Diffusionsverfahren hergestellt werden. Diese Strukturen könnten für vergrabene Subkollektoren und vergrabene Leiter gebraucht werden.

Die aus dem Substrat 10 der $N^+$-Schicht 12 und der $N^-$-Schicht 14 bestehende Struktur wird hergestellt durch eine photolithographische Technik. Diese ergibt sich durch selektives Ätzen, um schmale, flache Kanäle 16 zu erzeugen, die senkrechte Seitenwände 18 und horizontale Grundflächen 20 aufweisen, gemäss der Darstellung nach Fig. 1. Wie dies später noch genauer beschrieben wird, haben die flachen Kanäle eine Breite von ungefähr 2,5 $\mu$ oder weniger, so dass die Kanäle in erster Linie durch Ablagerung an den senkrechten Seitenwänden gefüllt werden, d. h. die Kanäle werden, ausgehend von den Seitenwänden und nicht ausgehend von den Grundflächen gefüllt. Dies unterscheidet sich von der Auffüllung eines verhältnismässig breiten Kanals, die dickere Füllschichten benötigen würde.

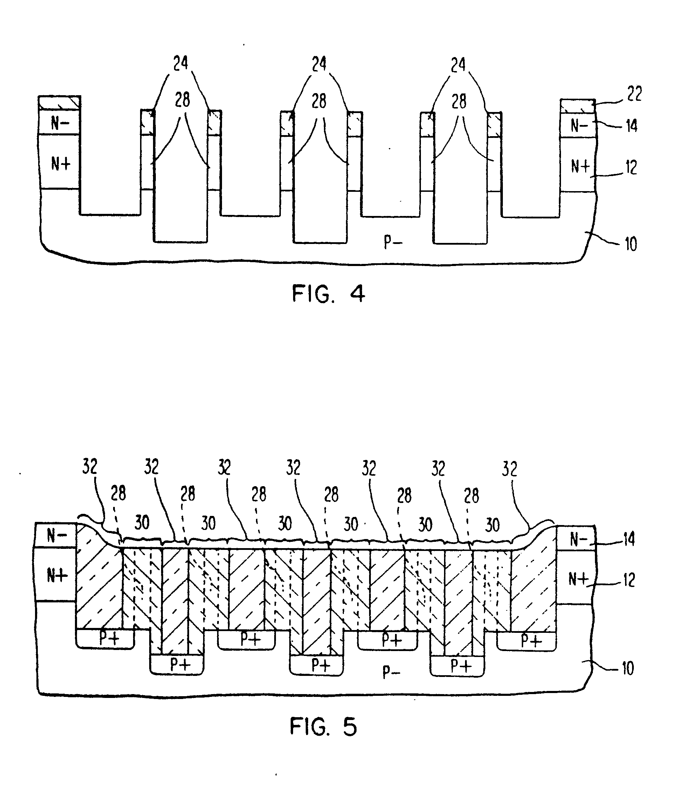

Gemäss der Darstellung nach Fig. 2 wird eine gleichförmige Schicht 22 eines Maskenmaterials an der Oberfläche der in Fig. 1 gezeigten Struktur aufgetragen. Diese Beschichtung erfolgt durch ein Aufdampfverfahren oder durch eine Plasma-Beschichtung, so dass die Deckschicht in gleichförmiger Dicke an den Horizontal- und Vertikal-Flächen der geätzten Halbleiterstruktur aufgetragen wird. Die Dicke der Schicht 22 ist gleich der Breite einer der in Abständen angeordneten, anhand der Fig. 4 beschriebenen Halbleiterzwischenwände.

Der beschichtete Halbleiterkörper wird einem reaktiven Ionenätzen ausgesetzt, um die Schicht 22 von den horizontalen Oberflächenteilen zu entfernen, so dass die Schicht 22 nur noch an den senkrechten Oberflächenteilen der Struktur gemäss der Darstellung nach Fig. 3 erhalten bleibt. Ein geeignetes Dampf-Beschichtungsverfahren und ein reaktives Ionenätzen für das Abtragen der Schicht 22 von den Horizontal-Oberflächen der Struktur werden beschrieben durch die europäische Patentanmeldung EP 7 910 33 51.7 (EP-A-10 596). Aus dieser Beschreibung geht hervor, dass es wichtig ist, dass der geätzte Halbleiterkörper gemäss der Darstellung nach Fig. 1, senkrechte Seitenflächen aufweist, die eine Neigung zur Grundfläche von weniger als 5° aufweisen, so dass nach dem Ionenätzen die in Fig. 3 gezeigte Struktur erreicht wird. Die gleichförmige Schicht 22 kann aus einer Vielzahl von Materialien oder Material-Kombinationen bestehen, die Siliciumdioxid, Siliciumnitrid oder Aluminiumoxid enthalten.

Das gewünschte Ergebnis des beschriebenen Ätzvorgangs ist in Fig. 3 dargestellt, wobei die gleichförmige Beschichtung 22 von den Horizontalflächen des Halbleiterkörpers entfernt wird. Es ergibt sich keine Wirkung an den Vertikalflächen 18 der Schicht in den Kanälen 16. Das Ergebnis sind die schmalen Bereiche 24 der ursprünglich gleichförmigen Schicht 22, gemäss der Darstellung nach Fig. 3.

Die in Fig. 3 gezeigte Struktur wird einem reaktiven Ionenätzen ausgesetzt, um die gewünschte Breite und Tiefe der Kanäle zu erreichen, indem die übrig gebliebenen gleichförmigen Schichtteile 24 als Ätzmaske benützt werden. Fig. 4 zeigt das Ergebnis dieses Verfahrens. Es sei darauf hingewiesen, dass alle Kanäle sich bis zum Bereich P⁻ des Substrats 10 erstrecken.

Es ist bekannt, dass die Bildung eines P⁻-Bereiches unterhalb des dielektrischen Materials, das dazu benützt wird, die geätzten, in Fig. 4 dargestellten Kanäle zu füllen, erwünscht ist, wenn das Substrat aus einem P⁻-Material, entsprechend dem vorliegenden Beispiel, besteht. Der P⁻-Bereich hat die Neigung, seinen Widerstandswert zu ändern, sogar so weit, dass sein Material sich zu dem N-Typ ändert, wenn es einer thermischen Oxidation unterworfen wird. Eine P⁺-Implantation in das Substrat 10 an den Grundflächen der einzelnen geätzten Kanäle verhindert die Möglichkeit einer solchen Umkehrung. Dies kann durch den Gebrauch einer P⁺-Ionenimplantation einer Dotierung, wie z. B. durch Bor, verhindert werden. Dementsprechend wird eine dünne Schicht aus Siliciumdioxid an der in Fig. 4 gezeigten Struktur aufgebracht, die als ein Schutzschirm für die erwähnte Bor-Ionen-Implantation dient, und die Ionenimplantation wird durchgeführt, um die in Fig. 5 gezeigten P⁺-Stopschwellen 26 zu erzeugen.

Nach dem Implantations-Verfahrensschritt wird die Struktur thermisch oxidiert, um das ganze Silicium der in Fig. 4 dargestellten Zwischenwände 28 in Siliciumdioxid zu verwandeln. Das thermisch gewachsene Siliciumdioxid der Zwischenwände füllt jeweils die Regionen 30, gemäss der Darstellung nach Fig. 5 aus. Nach diesem Verfahrensschritt verbleiben in den, gemäss der Darstellung nach Fig. 5 verbleibenden Regionen 30 ungefüllte Zwischenräume 32. Diese werden durch das Aufdampfen oder Plasma-Ablagerung von Siliciumdioxid oder durch anderes dielektrisches Material gefüllt. Das aufgebrachte dielektrische Material wird von den Oberflächen des Halbleiterkörpers in bekannter Weise entsprechend den Gebieten 34 durch selektives Ionenätzen entfernt. Der breite, tief eingeschnittene Isolationsgraben, der gemäss der Darstellung nach Fig. 5 mit dielektrischem Material gefüllt wird, ergibt eine Struktur, die signalübertragende Leiter aufnehmen kann, welche ein Minimum an kapazitiver Kopplung zu dem darunterliegenden Substrat 10 aufweisen.

## Patentansprüche

1. Verfahren zur Herstellung von breiten, tief eingeschnittenen Isolationsgräben in einem Halbleitersubstrat, bei dem

a) schmale, flache Kanäle (16) in die Oberfläche des Halbleitersubstrats eingefügt werden, die senkrechte Seitenflächen (18) aufweisen und die durch Profile mit mesaförmigem Querschnitt voneinander getrennt sind;

b) die Boden- und Seitenflächen (20, 18) der in das Halbleitersubstrat eingefügten Kanäle (16) und die Oberflächen der mesaförmigen Profile mit einem Maskenmaterial (22) beschichtet werden;

c) das Maskenmaterial von den Bodenflächen (20) der Kanäle (16) und von den Deckflächen der Profile durch reaktives Ionenätzen abgetragen wird;

d) das Halbleitersubstrat einer reaktiven Ionenätzung unterworfen wird, wobei das an den Seitenflächen der Kanäle verbliebene Maskenmaterial (24) als Ätzmaske dient, um eine Folge tiefer Gräben zu erzeugen, die durch schmale mesaförmige Zwischenwände (28) voneinander getrennt sind;

e) die Breite der Zwischenwände (28) durch die Schichtdicke des Maskenmaterials (22) bemessen ist; und

f) das Material der Zwischenwände vollständig thermisch oxidiert wird.

2. Verfahren nach Anspruch 1, dadurch gekennzeichnet, dass gegebenenfalls verbleibende Zwischenräume (32) zwischen den oxidierten Zwischenwänden (30) mit dielektrischem Material gefüllt werden.

## Claims

1. Method of making wide, deep recessed isolation trenches in a semiconductor substrate, where

a) narrow, shallow trenches (16) are formed in the surface of the semiconductor substrate, said trenches having vertical sidewalls (18) and being separated from each other by profiles with a mesa cross section;

b) the bottom and sidewall surfaces (20, 18) of the trenches (16) formed in the semiconductor substrate, as well as the surfaces of the mesa profile are coated with a masking material (22);

c) the masking material is removed from the bottom surfaces (20) of the trenches (16) and from the covering surfaces of the profiles by means of reactive ion etching;

d) the semiconductor substrate is exposed to a reactive ion etching, the masking material (24) remaining at the sidewalls of the trenches being used as an etching mask in order to produce a series of deep trenches separated from each other by means of narrow mesa sidewalls (28);

e) the width of the sidewalls (28) is determined by the layer thickness of the masking material (22); and

f) the material of the sidewalls is completely thermally oxidized.

2. Method as claimed in claim 1, characterized in that any remaining spaces (32) between the oxidized sidewalls (30) are filled with a dielectric material.

## Revendications

1. Procédé pour la réalisation de fossés d'isolation larges et profonds dans un substrat semiconducteur, dans lequel:

a) on forme dans la surface du substrat semiconducteur des canaux (16) étroits et plats, qui présentent des surfaces latérales (18) verticales et qui sont séparés les uns des autres par des profils ayant une section de forme mésa;

b) on recouvre d'un matériau de masquage (22) les surfaces de fond (20) et latérales (18) des canaux (16) formés dans le substrat semiconducteur, ainsi que les surfaces des profils de forme mésa;

c) le matériau de masquage est enlevé des surfaces de fond (20) des canaux (16) et des surfaces supérieures des profils par corrosion par ions réactifs;

d) le substrat semiconducteur est soumis à une corrosion par ions réactifs, le matériau de masquage (24) qui est resté sur les surfaces latérales des canaux servant de masque anti-corrosion, pour former une suite de fossés profonds séparés les uns des autres par des cloisons étroites (28) de forme mésa;

e) la largeur des cloisons (28) est déterminée par l'épaisseur du matériau de masquage (22); et

f) le matériau des cloisons est totalement oxydé, par action thermique.

2. Procédé selon la revendication 1, caractérisé en ce que les éventuels espaces intermédiaires résiduels (32) entre les cloisons exodées (30) sont remplis de matériau diélectrique.

FIG. 1

FIG. 2

FIG. 3

FIG. 4

FIG. 5